Europäisches Patentamt

European Patent Office

Office européen des brevets

(11) Publication number : **0 484 288 A1**

# EUROPEAN PATENT APPLICATION

(21) Application number : **91830449.4**

(22) Date of filing : **22.10.91**

(51) Int. Cl.⁵ : **H05K 5/02**

(30) Priority : **30.10.90 IT 5334790 U**

(43) Date of publication of application :
**06.05.92 Bulletin 92/19**

(84) Designated Contracting States :
**DE ES FR GB SE**

(71) Applicant : **MARELLI AUTRONICA S.p.A.**
**Via Griziotti 4**
**I-20145 Milano (IT)**

(72) Inventor : **Saja, Luca**
**Via Ventimiglia 160**
**I-10126 Torino (IT)**

(74) Representative : **Quinterno, Giuseppe et al**
**c/o Jacobacci-Casetta & Perani S.p.A. Via**
**Alfieri, 17**
**I-10121 Torino (IT)**

(54) **A container with a breather device for electrical and/or electronic circuits.**

(57) The container has an electrical connector (4, 4a) fixed by means of two screws (5) which extend with clearance through holes (6) in a wall (2a) of the container (1 to 3) and engage corresponding seats (7) in the connector (4, 4a). At least one groove (8) in the wall of each seat (7) communicates at one end with the annular space (9) defined between the screw (5, 5a) and the surrounding wall of the hole (6) and opens within the container (1 to 3) at its other end so as to define a narrow breather duct which enables communication between the interior of the container (1 to 3) and the outside atmosphere.

FIG. 1

EP 0 484 288 A1

Jouve, 18, rue Saint-Denis, 75001 PARIS

The present invention relates to a container for electrical and/or electronic circuits, particularly a container for an electronic unit for controlling a function of an internal combustion engine for motor vehicles such as a unit for controlling the ignition and/or electronic fuel-injection.

More specifically, the invention relates to a container having at least one multipole electrical connector fixed within the container in a hole in a wall thereof, by means of at least one fixing screw which extends with clearance through a hole in the wall of the container and engages a corresponding seat in the connector.

The container according to the invention is characterised in that at least one groove along the wall of the seat communicates at one end with the annular space defined between the screw and the surrounding wall of the hole in the container and opens within the container at its other end so as to define a narrow breather duct which enables communication between the interior of the container and the outside atmosphere.

According to a further characteristic, a filter element may be fitted to the mouth of the narrow breather duct which opens within the container to allow gaseous substances to pass in both directions but to prevent the passage of liquids.

Further characteristics and advantages of the invention will become clear from the detailed description which follows, with reference to the appended drawings, provided purely by way of non-limiting example, in which:

Figure 1 is a perspective view of a container according to the invention,

Figure 2 is a partial sectional view taken on the line II-II of Figure 1,

Figure 3 is a partial sectional view taken on the line III-III of Figure 2, and

Figure 4 is a view similar to that of Figure 2, showing an embodiment in which a filter element is fitted to the narrow breather duct.

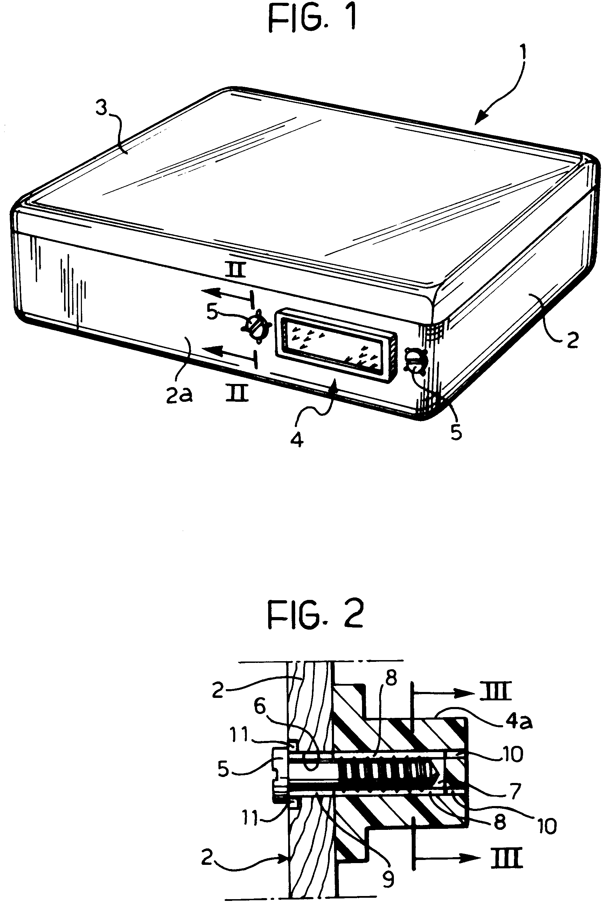

In Figure 1, a container for electrical and/or electronic circuits according to the invention is generally indicated 1. The container includes a substantially dish-shaped lower portion 2, for example of diecast aluminium, coupled sealingly with an upper lid 3.

A multipole electrical connector, generally indicated 4 in Figure 1, is fixed to a side wall 2a of the lower portion 2 of the container. The connector is fixed within the container 1 in a hole (which is rectangular in the embodiment shown by way of example) in the wall 2a.

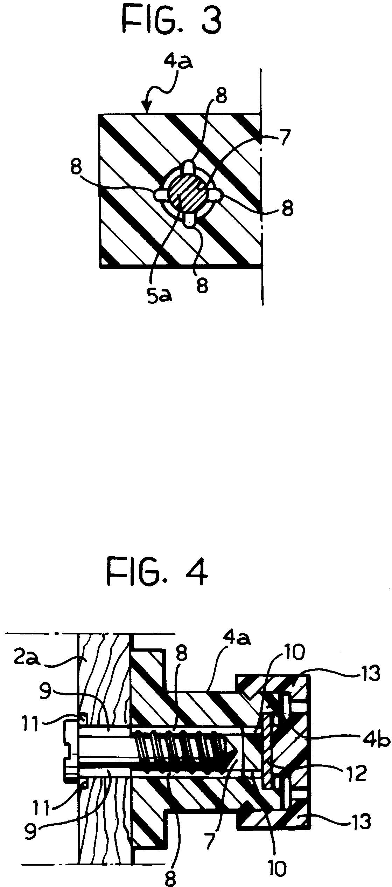

The body of the connector 4 has two side portions 4a (of which only one is visible in Figures 2 to 4) by which it is fixed to the wall 2a of the container by screws 5. As can be seen in Figures 2 and 3, for each end 4a of the connector, the wall 2a of the container has a through-hole 6, through which a portion of the shaft 5a of a screw 5 extends with clearance. The end portions 4a of the body of the connector 4 correspondingly have two seats 7 in the form of cylindrical holes with smooth walls.

Conveniently, the screws 5 are of the self-tapping type and the diameters of their threads are larger, at least on average, than the diameters of the walls of the seats 7.

In the embodiments shown in Figures 2 and 4, the seats 7 are blind but they could be through-holes.

In any case, according to the invention, grooves 8 extend along the walls of the seats 7 preferably (but not necessarily) longitudinally and one end of each groove communicates with the annular space 9 defined between the shaft of the screw 5 and the surrounding wall of the hole 6 in the container.

The other end of each groove 8 opens within the container 1. In embodiments which, like those illustrated, have blind seats 7, the grooves 8 extend axially beyond the end walls of the seats to form corresponding through-holes 10 which open within the container.

The radial depths of the grooves 8 are such that the tips of the threads of the screws 5 do not obstruct the grooves completely but leave ducts open between the tips of the threads and the bases of the grooves.

The grooves 8, the annular space 9 and the holes 10 together constitute a series of breather ducts which enable air to pass from the interior of the container 1 to the outside atmosphere and vice versa. These ducts conveniently have narrow transverse dimensions so as to prevent the passage of liquids.

Preferably, the wall 2a of the container has radial ducts such as those indicated 11 in Figures 2 and 4 for communication between the annular spaces 9 and the outside atmosphere. These ducts ensure that the annular space 9 communicates with the atmosphere outside the container even when the screws 5 are screwed in very tightly.

As can be seen in Figure 4, the mouths of the breather ducts, defined above, which open within the container may be associated with a filter element 12 allowing gaseous substances to pass in both directions but preventing the passage of liquids. The filter element may be made of the material known by the trade name Gore-Tex. In the embodiment shown by way of example in Figure 4, the filter element 12 is in the form of a disc which is positioned in a recess 4b in the body of the electrical connector 4 and kept in position by an associated perforated retaining element 13 snap-engaged on the body of the connector.

The breather ducts described above enable the pressure within the container 1 to be brought into equilibrium with the external pressure, for example, when the internal pressure tends to rise considerably as a result of the thermal expansion of the air confined in the container.

## Claims

1.  A container for electrical and/or electronic circuits, particularly a container for an electronic unit for controlling a function of an internal combustion engine for motor vehicles, having at least one multipole electrical connector (4, 4a) fixed within the container (1 to 3), in a hole in a wall (2a) thereof, by means of at least one fixing screw (5) which extends with clearance through a hole (6) in the wall (2a) of the container (1 to 3) and engages a corresponding seat (7) in the connector (4, 4a),
    characterised in that at least one groove (8) in the wall of the seat (7) communicates at one end with the annular space (9) defined between the screw (5, 5a) and the surrounding wall of the hole (6) in the container (1, to 3) and opens into the container (1 to 3) at its other end so as to define at least one narrow breather duct which enables communication between the interior of the container (1 to 3) and the outside atmosphere.

2.  A container according to Claim 1, characterised in that it has at least one radial duct (11) for communication between the annular space (9) defined between the screw (5, 5a) and the surrounding wall of the hole (6) in the container and the outside atmosphere.

3.  A container according to Claim 1 or Claim 2, in which the screw (5) is of the self-tapping type and the corresponding seat (7) has a predetermined diameter smaller than the average diameter of the thread of the screw (5),
    characterised in that the depth of the at least one groove (8) is such that breather ducts remain open between its base and the tips of the threads of the screw ( 5, 5a).

4.  A container according to any one of the preceding claims, in which the seat (7) for the at least one screw (5) is blind, characterised in that the groove (8) extends axially beyond the end wall of the seat (7) to form a through-hole (10) which opens within the container (1 to 3).

5.  A container according to any one of the preceding claims, characterised in that a filter element (12) is fitted to the mouth of the breather duct (9 to 10) which opens within the container to allow gaseous substances to pass in both directions but to prevent the passage of liquids.

6.  A container according to Claim 5, characterised in that a perforated retaining element (13) associated with the filter element (12) is snap-engaged on the connector (4, 4 a).

# FIG. 1

# FIG. 2

# FIG. 3

# FIG. 4

**European Patent Office**

# EUROPEAN SEARCH REPORT

Application Number

EP 91 83 0449

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | FR-A-2 631 748 (AIR LB INTERNATIONAL)<br>* page 4, line 25 - line 29; figure 2 *<br>--- | 1,5 | H05K5/02 |
| Y | EP-A-0 377 067 (W.L. GORE & ASSOCIATES GMBH)<br>* page 3, column 4, line 12 - line 23; figures 1,2 *<br>--- | 1,5 | |
| A | EP-A-0 353 110 (LUDWIG SCHMITT GMBH)<br>* page 2, column 2, line 22 - line 48; figures 1,2 *<br>--- | 1 | |
| A | WO-A-9 008 393 (SIEMENS AG)<br>* page 4, line 23 - line 32; figure 2 *<br>----- | 1 | |
|  |  |  | TECHNICAL FIELDS SEARCHED (Int. Cl.5 ) |
|  |  |  | H05K |

The present search report has been drawn up for all claims

| Place of search | Date of completion of the search | Examiner |
|---|---|---|
| THE HAGUE | 06 FEBRUARY 1992 | RUBENOWITZ A. |

EPO FORM 1503 03.82 (P0401)